# EUROPEAN PATENT SPECIFICATION

(11) **EP 4 550 417 B1**
(45) Date of publication and mention of the grant of the patent: **18.11.2026**
(21) Application number: 24208853.2
(22) Date of filing: 25.10.2024
(51) Int. Cl.: H10W 70/60, H10W 70/692, H05K 1/03, H05K 1/185, H05K 3/42, H10W 70/05, H10W 70/68, H10W 70/63

(54) **PACKAGING SUBSTRATE AND MANUFACTURING METHOD OF PACKAGING SUBSTRATE**
VERPACKUNGSSUBSTRAT UND HERSTELLUNGSVERFAHREN FÜR VERPACKUNGSSUBSTRAT
SUBSTRAT D'ENCAPSULATION ET PROCÉDÉ DE FABRICATION DE SUBSTRAT D'ENCAPSULATION

(30) Priority: 31.10.2023 US 202363594430 P
(43) Date of publication of application: 07.05.2025
(73) Proprietor: Absolics Inc., Covington, GA 30014 (US)
(72) Inventor: LEE, Bongyeol, Covington, GA 30014 (US); KIM, Hyejin, Covington, GA 30014 (US)
(74) Representative: BCKIP Part mbB

(56) References cited:
- EP-A1- 3 916 771
- US-A1- 2011 133 342
- US-A1- 2018 199 438
- US-A1- 2020 105 703
- US-A1- 2021 175 159

## Description

### 1. Technical Field of the Invention

This invention relates to a packaging substrate and to a manufacturing method of a packaging substrate.

### 2. Description of Related Art

When building an electronic component, implementing the circuitry on a semiconductor wafer is called the front end (FE), and assembling the wafer into a product ready state is called the back end (BE). The latter includes the packaging process.

The four core technologies of the semiconductor industry that have enabled the rapid development of electronic products in recent years are semiconductor technology, semiconductor packaging technology, manufacturing process technology, and software technology.

Semiconductor technology is advancing in many ways, including submicron to nanoscale linewidths, 10 million or more cells, high speed operation, and lots of heat dissipation, but the technology to package them perfectly is still relatively new.

Therefore, the electrical performance of a semiconductor is often determined by the packaging technology and its electrical connections rather than the performance of the semiconductor technology itself.

Substrates for packaging can be made of ceramic or resin. Ceramic substrates, such as silicon substrates, have high resistivity or high dielectric constant, making it difficult to mount high performance, high frequency semiconductor elements. **In** the case of resin substrates, it is possible to mount relatively high performance, high frequency semiconductor elements. However, there are limitations in reducing the pitch of the wiring.

Recently, silicon or glass can be used as substrates for High End Packaging. By forming through holes in the silicon or glass substrate and applying conductive materials to the through holes, the wiring between the element and the motherboard can be shortened and have good electrical characteristics.

In addition, the semiconductor package may generate heat during operation and may further include heat dissipation means for dissipating such heat.

EP 3 916 771 A1 discloses a semiconductor device comprising a semiconductor element unit where one or more semiconductor elements are disposed, a packaging substrate electrically connected to the semiconductor element, and a motherboard electrically connected to the packaging substrate, transmitting electrical signals of the semiconductor element and external, and connecting each other. The packaging substrate also can comprise a core layer, an upper layer disposed on one surface of the core layer, and a cavity unit where a cavity element is possible to be disposed. US 2018/199438 A1 discloses forming a multilayer glass core comprising a first glass and a second glass.

### SUMMARY OF THE INVENTION

To achieve the above objectives, the present invention provides a packaging substrate according to claim 1 and a method for manufacturing a packaging substrate according to claim 7.

According to the present invention, the packaging substrate includes a core layer, the core layer comprising: a glass core having first and second surfaces facing each other; a cavity portion opening recessed in the direction of the first surface or the second surface; and a plurality of core vias penetrating the glass core in a thickness direction.

The core via comprising: a first opening abutting the first surface; a second opening abutting the second surface; and a minimum inner diameter region, which is a region having the narrowest inner diameter in the entire core via connecting the first opening and the second opening.

The core via comprises a first core via and a second core via having different heights at which the minimum inner diameter regions are disposed.

A second zone of the glass core is the zone in which the cavity portion is disposed in the glass core, and a first zone of the glass core is the zone in which the cavity portion is not disposed in the glass core.

A first core via is disposed in the first zone and has a minimum inner diameter region at a first position, and a second core via is disposed in the second zone and has a minimum inner diameter region at a second position.

With respect to the second surface, a minimum inner diameter height of the first core via may be positioned higher than a minimum inner diameter height of the second core via.

The glass core includes a first glass and a second glass laminated up and down. The first glass includes a through cavity. And the glass core includes a bonding interface between a lower surface of the first glass and an upper surface of the second glass.

The second glass has a recessed surface.

An angle of the sidewall surface of the through cavity of the first glass and an angle of the sidewall surface at the recessed surface of the second glass may be different.

Electronic elements may be arranged in the internal space of the cavity portion.

The electronic element may include an active element and/or a passive element.

In one or more embodiments, a packaging substrate includes a core layer, the core layer comprising: a glass core having first and second surfaces facing each other; a cavity portion having a surface recessed to open in the direction of the first surface; and a plurality of core vias penetrating the glass core in a thickness direction.

The glass core includes a first glass and a second glass stacked on top and bottom, and the first glass includes a through cavity.

A second zone of the glass core is a zone in which the cavity portion is disposed in the glass core.

The second glass may have a recessed surface.

A sidewall surfaces of the through cavity of the first glass and a sidewall surface of the recessed surface of the second glass are connected to each other, and in the cross-section of the second zone, the internal space of the cavity portion is hexagonal in shape.

The cavity portion is divided into a first section for a region aligned with the first glass and a second section for a region aligned with the second glass.

A width of the cavity portion of the second section may be narrower than a width of the cavity portion of the first section.

A taper angle of the sidewall surface of the cavity portion may be 87 degrees to 90 degrees.

In one or more embodiments, a packaging substrate includes a core layer, the core layer comprising: a glass core having first and second surfaces facing each other; and a plurality of core vias penetrating the glass core in a thickness direction.

The glass core may comprise a first glass and a second glass stacked on top and bottom, and an interface of the first glass and the second glass may be bonded in a chemical structure forming a Si-O-Si or O-Si-O structure.

The interface of the first glass and the second glass may substantially not comprise a polymeric adhesive layer.

The first glass may comprise a through cavity.

The glass core may further comprise a cavity portion having a surface recessed and provided with an internal space opened in the first direction.

In one or more embodiments, a manufacturing method of a packaging substrate including operations of: forming a first core bonding a first glass having a through cavity and a second glass; and etching the first core to form a plurality of core vias; so, preparing a glass core. The glass core has a first surface and a second surface facing each other. The core via has an internal space arranged with a recessed surface opening in the direction of the first surface. The core via penetrates the glass core in a thickness direction. The core via has a first opening abutting the first surface; a second opening abutting the second surface; and a minimum inner diameter region which is the narrowest inner diameter region of the entire core via connecting the first opening and the second opening.

The glass core may comprise a first core via and a second core via having different heights at which the minimum inner diameter regions are disposed.

A second region of the glass core is a region in which the cavity portion is disposed in the glass core.

The second glass may have a recessed surface.

A sidewall surfaces of the through cavity of the first glass and a sidewall surface of the recessed surface of the second glass are connected to each other, and in the cross-section of the second region, the internal space of the cavity may be hexagonal in shape.

The bonding in the operation of forming a first core may be anodic bonding.

### BRIEF DESCRIPTION OF THE DRAWINGS

FIG. 1 is a conceptual diagram illustrating a cross-sectional structure of a packaging substrate, according to an embodiment.
FIG. 2 is a conceptual diagram illustrating a cross-sectional structure of a packaging substrate, according to another embodiment.
FIGS. 3A and 3B are conceptual diagrams illustrating a cross-sectional view of a portion of a packaging substrate, according to an embodiment, respectively.
FIGS. 4A to 4E are cross-sectional flowcharts illustrating a process for creating a core distribution layer during the manufacturing of a packaging substrate, according to an embodiment.
FIGS. 5A to 5E are cross-sectional flowcharts illustrating a process for creating an insulating layer during manufacturing of a packaging substrate, according to an embodiment.
FIGS. 6A to 6C are cross-sectional flowcharts illustrating a process for generating a glass core having a half-cavity, according to an embodiment.
FIG. 7 is a conceptual diagram illustrating a cross-sectional view of a core layer comprising a glass core having a half-cavity created in accordance with an embodiment.
FIG. 8 is a conceptual diagram illustrating a cross-sectional view of the structure of a packaging substrate generated in accordance with an embodiment.

### DETAILED DESCRIPTION OF EXEMPLARY EMBODIMENETS

In order to provide a comprehensive understanding of the methods, apparatus, and/or systems described herein, the following detailed description is provided. However, for example, the sequence of operations described herein is by way of example only and is not intended to be limiting to the operations described herein. Except for operations that are not necessarily performed in a particular order, the order of operations may be altered based on an understanding of what is disclosed herein. In addition, descriptions of features already known in the art may be omitted for clarity and brevity after understanding the invention of this application. However, the omission of such features and their descriptions is not intended to be recognized as general knowledge.

The features described herein may be implemented in different forms and are not to be construed as being limited to the examples described herein. Rather, the embodiments described herein are provided to illustrate some of the many possible ways of implementing the methods, devices, and/or systems described herein that will become apparent after understanding the inventions of this application.

The terms "first," "second," "third," and the like may be used herein to describe various members, components, regions, layers, or sections, but are not intended to limit the members, components, regions, layers, or sections to these words. Instead, these terms are used for the purpose of distinguishing one member, component, region, layer, or section from another member, component, region, layer, or section. Thus, a first member, component, region, layer, or section referred to in the embodiments described herein may also be referred to as a second member, component, region, layer, or section without departing from the teachings of the embodiments.

Throughout the specification, when an element, such as a layer, region, or substrate, is described as being "on," "connected to," or "coupled to" another element, it may be described as being directly "on," "connected to," or "coupled to" the other element, or it may have one or more other elements interposed between them. In contrast, when an element is described as "directly on", "directly connected to", or "directly joined to" another element, no other element can intervene between them. Similarly, for example, expressions such as "between" and "directly between," and "abutting" and "directly abutting" can also be interpreted as described above.

The terms used in this specification are intended to describe specific examples and are not intended to limit invention. The singular form used herein is intended to include the plural form unless the context clearly indicates otherwise. As used herein, the term "and/or" includes any one or a combination of two or more of the relevant list items. The terms "comprising," "consisting of," and "having" as used herein specify the presence of the specified features, numbers, actions, elements, components, and/or combinations thereof, but do not exclude the presence or addition of one or more other features, numbers, actions, elements, components, and/or combinations thereof. The use of the term "may" in this specification with respect to an example or embodiment (e.g., with respect to what an example or embodiment may include or implement) implies that there is at least one example or embodiment that includes or implements such features, but all examples are not limited thereto.

For the purposes of this application, "B being located on A" means that B is disposed on top of A, either in direct contact with A or with another layer or structure interposed therebetween, and should not be construed to mean that B is in direct contact with A.

Unless otherwise defined, all terms used herein shall have the same meaning as commonly understood by one of ordinary skill in the art to which the present invention belongs. Terms such as those defined in commonly used dictionaries are to be construed to have meanings consistent with their meaning in the context of the prior art and the present invention and are not to be construed in an idealized or overly formal sense unless expressly defined herein.

In one or more of the examples above, a description of "A and/or B" means "A, B, or A and B".

In one or more of the above examples, terms such as "first," "second," "A," or "B" are used to distinguish identical terms from each other.

In one or more of the above examples, a singular form is contextually interpreted to include the plural as well as the singular, unless otherwise noted.

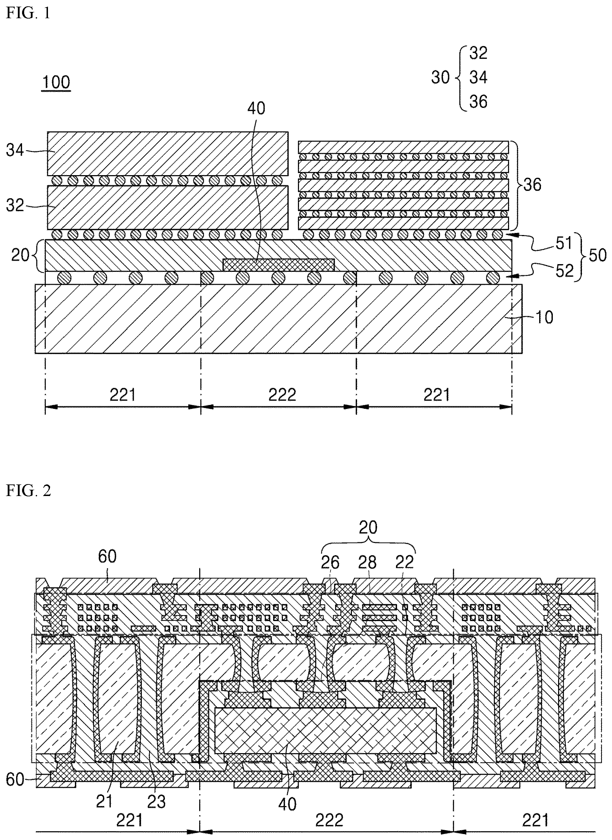

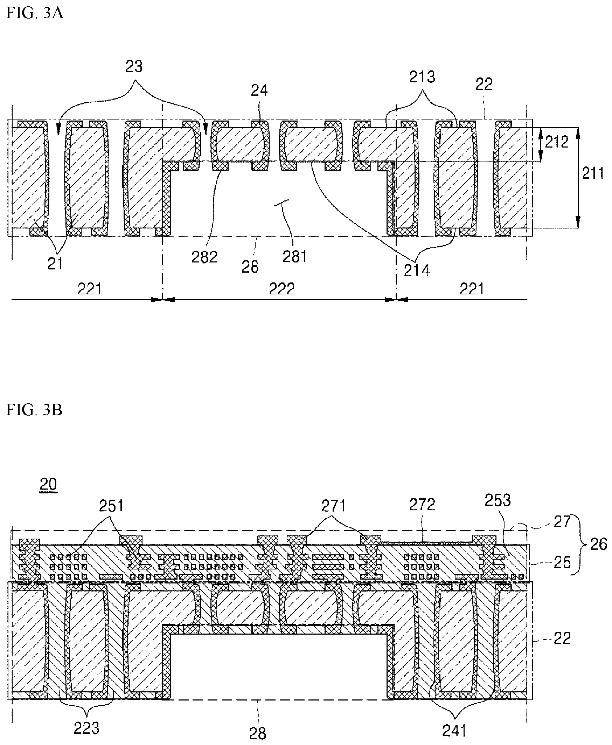

FIG. 1 is a conceptual diagram illustrating a cross-sectional structure of a packaging substrate according to an embodiment, FIG. 2 is a conceptual diagram illustrating a cross-sectional structure of a packaging substrate according to another embodiment, and FIGS. 3A and 3B are conceptual diagrams illustrating a cross-sectional view of portions of a packaging substrate according to embodiments, respectively.

To accomplish the above objectives, a semiconductor device 100 according to an embodiment comprises a semiconductor element portion 30 on which one or more semiconductor elements 32, 34, 36 are located; a packaging substrate 20 electrically connected to the semiconductor elements; and a motherboard 10 electrically connected to the packaging substrate 20 and transmitting external electrical signals to and connecting the semiconductor elements 32, 34, 36 with each other.

The packaging substrate 20, according to one embodiment, comprises a core layer 22, an upper layer 26 positioned on a first surface of the core layer 22, and a cavity portion 28 in which an electronic element 40 can be located.

The semiconductor element portion 30 refers to an element mounted on a semiconductor device and is mounted on the packaging substrate 20 by means of a connection electrode or the like. Specifically, the semiconductor element portion 30 can be applied to, for example, a computing element (first element: 32, second element: 34) such as a CPU or GPU, a memory element (third element, 36) such as a memory chip, etc.

The motherboard 10 may be a motherboard such as a printed circuit board, a printed wiring board, or the like.

The packaging substrate 20 may optionally further comprise a lower layer (not shown) located below the core layer.

A glass core 21 may comprise the core layer 22 comprising a first zone 221 having a first thickness 211 and a second zone 222 having a second thickness 212 that is adjacent to the first zone 221 and is less than the first thickness; a plurality of core vias 23 penetrating the glass core 21 in a thickness direction; and a core distribution layer 24 located on a surface of the glass core 21 or core vias 23 and electrically connecting, via the core vias 23, a first surface 213 of the glass core 21 and a second surface 214 facing the first surface 213.

The second zone 222 of the core layer 22 may serve as a cavity structure.

Within the same zone, the glass core 21 has a first surface 213 and a second surface 214 that face each other, and these two surfaces are substantially parallel to each other and have a constant thickness throughout the glass core 21.

The internal space 281 formed by the difference in thickness of the first zone 221 and the second zone 222 serves to house some or all of the electronic elements 40.

The glass core 21 may comprise core vias 23 through the first surface 213 and the second surface 214. The core vias 23 may be formed in both the first zone 221 and the second zone 222 and may be formed in any desired pitch and pattern.

As a packaging substrate for semiconductor devices, silicon substrates and organic substrates have traditionally been applied in a laminated form. In the case of silicon substrates, due to the nature of semiconductors, parasitic elements may occur when applied to high-speed circuits, and power losses are relatively high. In addition, organic substrates require large area to form more complex distribution patterns, which is inconsistent with the trend of miniaturization of electronic devices. In order to form a complex distribution pattern within a certain size, pattern refinement is practically necessary, but there were practical limitations in pattern refinement due to the characteristics of materials such as polymers applied to organic plates.

In an embodiment, the glass core 21 is applied as a support for the core layer 22 as a way to solve these problems. In addition, a core via 23 formed through the glass core 21 is applied in conjunction with the glass core 21 to provide a packaging substrate 20 having shorter electrical flow lengths, more miniaturized, faster response, and lower loss characteristics.

The glass core 21 may preferably be a glass substrate applied to a semiconductor, for example, a borosilicate glass substrate, an alkali-free glass substrate, and the like, but is not limited thereto.

The core via 23 penetrates the glass core 21. The core via 23 may be formed by removing a predetermined area of the glass core 21, in particular by etching the plate glass by physical and/or chemical means.

Specifically, the formation of the core vias 23 may be accomplished by forming defects (flaws) on the surface of the glass core by means of a laser or the like, followed by chemical etching, laser etching, and the like, but is not limited to.

The core vias 23 may be 100 to 3,000 in number, 100 to 2,500 in number, 225 to 1,024 in number, or 225 to 1,024 in number based on a unit area (1 cm x 1 cm) of the glass core 21. If these pitch conditions are satisfied, the formation of an electrically conductive layer or the like and the performance of the packaging substrate can be improved.

The core distribution layer 24 comprises a core distribution pattern 241, an electrically conductive layer electrically connecting the first and second surfaces of the glass core via through vias, and a core insulation layer 223 surrounding the core distribution pattern. The core layer 22 has an electrically conductive layer formed therein through the core vias, which acts as an electrical pathway across the glass core 21 and can connect the upper and lower parts of the glass core over a relatively short distance, resulting in faster electrical signal transmission and low loss. The electrically conductive layer may be, for example, but not limited to, a copper plating layer.

The cavity portion 28 is substantially circular, triangular, square, hexagonal, octagonal, cross-shaped, or otherwise non-limiting in shape.

The electronic element 40 may be generally cylindrical, cuboidal, or polygonal in shape.

The cavity portion 28 may comprise a cavity distribution pattern, which is an electrically conductive layer electrically connecting the electronic element 40 and the core distribution layer 24, and an insulating layer surrounding the cavity distribution pattern.

Alternatively, the cavity portion according to another embodiment may be implemented in a form that penetrates the first surface 213 and the second surface 214 of the glass core 21. In this case, the cavity portion may be formed according to the same process as the formation process of the core vias 23 and may differ from the core vias 23 in the area and shape through the glass core 21.

In such an implementation, an insulating layer may be created in the cavity portion after the electronic element 40 is arranged in the cavity portion, i.e., an insulating layer may be created in the cavity portion through the process of creating the core insulating layer 223 described above.

The core distribution pattern 241 may be patterned to be electrically coupled to the electronic element 40.

The electronic element 40 may comprise an active element, such as a transistor, or a passive element, such as a power transfer element, such as a multilayer ceramic capacitor (MLCC).

If an element such as a transistor, which plays a role in converting electrical signals between the motherboard and the semiconductor element portion to an appropriate level, is applied to the electronic element 40, the packaging substrate 20 may become a form in which a transistor or the like is applied in the path of the packaging substrate 20, thereby providing a semiconductor device 100 having a more efficient and faster speed.

In addition, power transfer elements, such as multilayer ceramic capacitors (MLCCs), play an important role in the performance of semiconductor devices. It is common for at least 200 or more power transfer elements, which are passive elements, to be applied to a semiconductor device, and their performance in transferring power is also affected by the characteristics of the electrically conductive layer surrounding the device. In one embodiment, non-circular shaped core via can be applied where a low resistance electrically conductive layer is required, such as in power transfer elements.

On the other hand, as the electronic element 40, the passive elements such as capacitors may be applied by being inserted individually, or it may be embedded between insulator layers (electronic element insulation layers) in such a way that a group of elements comprising a plurality of passive elements is formed so that the electrodes are exposed and then inserted as the electronic element. The latter option is more workable for packaging substrate fabrication and more favorable for ensuring that the insulating layer is sufficiently and reliably located in the space between complex elements.

The glass core 21 plays an intermediate role, an intermediary role, connecting the semiconductor element portion 30 and the motherboard 10 on the upper and lower sides, respectively, and the core via 23 acts as a passageway for transmitting electrical signals therebetween, thereby facilitating smooth signal transmission. For the purpose of distinguishing from the core via of the second zone 222 described later, the core via disposed in the first zone 221 will be referred to as the first zone core via 231.

Above the first surface 213 is the upper layer 26.

The upper layer 26 comprises an upper distribution layer 25 and an upper surface connection layer 27 located on the upper distribution layer 25, and the uppermost surface of the upper layer 26 may be protected by a cover layer 60 having an opening formed through which contact electrodes of the semiconductor element can directly contact.

The upper distribution layer 25 comprises an upper insulating layer 253 positioned on the first surface; and an upper distribution pattern 251 embedded in the upper insulating layer 253 as an electrically conductive layer having a predetermined pattern and electrically connecting at least a portion thereof with the core distribution layer 24. The upper distribution layers 25 disposed above and below each other may be connected to each other via blind vias 252.

The upper insulating layer 253 may be applied as an insulator layer to a semiconductor device or packaging substrate, and may be, for example, an epoxy-based resin containing fillers, but is not limited to.

The insulator layer may be formed by forming a coating layer and curing it, or it may be formed by laminating an uncured or semi-cured insulator film to the core layer 22 and curing it. In this case, by applying a pressure-sensitive lamination method or the like, the insulator can be embedded into the space inside the core vias 23 and the process can proceed efficiently.

In some implementations, the plurality of insulating layers may be stacked and substantially indistinguishable from one another, and the plurality of insulating layers are collectively referred to as the upper insulating layer. Additionally, the core insulation layer 223 and the upper insulation layer 253 may be made of the same insulating material, in which case the boundary between them may be substantially indistinguishable. Alternatively, in other implementations, the boundaries of the insulator layers may be created by setting different pressures and temperatures to cure the multiple insulator layers.

The upper layer pattern 251 refers to an electrically conductive layer located within the upper insulating layer 253 in a preset shape, which may be formed, for example, in a build-up layer method. Specifically, the upper distribution pattern 251 can be formed by forming an insulator layer, removing an unnecessary portion of the insulator layer, forming an electrically conductive layer by copper plating or the like, optionally removing an unnecessary portion of the electrically conductive layer, forming an insulator layer on top of the electrically conductive layer, removing an unnecessary portion of the insulator layer, forming an electrically conductive layer by plating or the like, and so on, so that the electrically conductive layer is formed in a vertical or horizontal direction in the desired pattern.

Since the upper distribution pattern 251 is located between the core layer 22 and the semiconductor element portion 30, it is formed to comprise a fine pattern in at least a portion thereof so that the transmission of electrical signals to the semiconductor element portion 30 can proceed smoothly and the intended complex pattern can be sufficiently accommodated. In this case, the fine pattern may have a width and spacing of less than 4 µm, 3.5 µm or less, 3 µm or less, 2.5 µm or less, or 1 to 2.3 µm, or the like (hereinafter, the description of the fine pattern will be the same).

The upper surface connection layer 27 comprises an upper surface connection pattern 272 located on the upper insulating layer 253 and electrically connected, at least partially, with the upper distribution pattern 251, and an upper surface connection electrode 271 electrically connecting the upper surface connection pattern 272 with the semiconductor element portion 30.

The upper surface connection pattern 272 may be located on a first surface of the upper insulating layer 253, or at least a portion thereof may be exposed and embedded in the upper insulating layer. For example, if the upper surface connection pattern is located on one side of the upper insulating layer, the upper insulating layer may be formed by plating or the like, and if the upper surface connection pattern is embedded with a part of it exposed on the upper insulating layer, it may be that a part of the insulating layer or the electrically conductive layer is removed by surface polishing, surface etching, or the like after forming a copper plating layer or the like.

The upper surface connection pattern 272 may comprise at least a portion of a fine pattern, such as the upper distribution pattern 251 described above. The upper surface connection pattern 272 comprising such fine patterns enables a larger number of elements to be electrically connected in a smaller area, allowing for smoother electrical signal connections between elements or to the outside world, and enabling more integrated packaging.

The upper surface connection electrode 271 may be directly connected to the semiconductor element portion 30 by terminals or the like or may be connected via an organic connection 51 such as a solder ball.

The cavity portion 28 comprises a cavity distribution layer 282 located above and/or below the second zone 222 and electrically connected to the core distribution pattern 241, and an internal space 281 in which the electronic elements 40 are located. The cavity distribution layer 282 may be formed through the second zone core via 232.

Specifically, the second zone 222 has a thinner thickness of the glass core 21 compared to the first zone 221, and the electronic element 40 may be located in the internal space 281 formed due to the difference in thickness. Furthermore, the core vias 23 formed in the glass core 21 and the core distribution layer 24 serve as an electrical connection structure connecting the electronic element 40 and the external element.

Furthermore, as described above, a cavity portion may be created in the form of penetrating the first zone 221, i.e., the first surface 213 and the second surface 214 of the glass core 1, rather than the second zone 222, and the electronic element 40 may be arranged in the cavity portion.

The packaging substrate 20 is also connected to a motherboard 10. The motherboard 10 may be electrically connected to the core distribution pattern 241 located on at least a portion of the second surface 214 of the core layer 22 by terminals of the motherboard 10, either directly or via a board connection 52 such as a solder ball. In addition, the core distribution pattern 241 in contact with the motherboard 10 may be connected to the motherboard 10 via a lower layer (not shown) located at the bottom of the core layer 22. The element connection portion 51 and the board connection portion 52 are collectively referred to as the connection portion 50.

In one example, no substantially additional substrate other than the glass core 21 may be applied to the packaging substrate 20 positioned between the semiconductor element portion 30 and the motherboard 10.

Traditionally, the interposer and organic substrate are laminated together between the element and the motherboard. There are at least two reasons for this multi-operation application: one is that there are scale issues with directly connecting the fine pattern of the element to the motherboard, and the other is that wiring damage can occur during the connecting process or during the driving process of the semiconductor element due to differences in thermal expansion coefficients.

The embodiment solves this problem by applying a glass core with a coefficient of thermal expansion similar to that of a semiconductor element and forming a fine-pattern on the first surface of the glass core and its upper layer with a scale fine enough for element mounting.

In the following, a manufacturing method for a packaging substrate according to an embodiment of the present invention will be described.

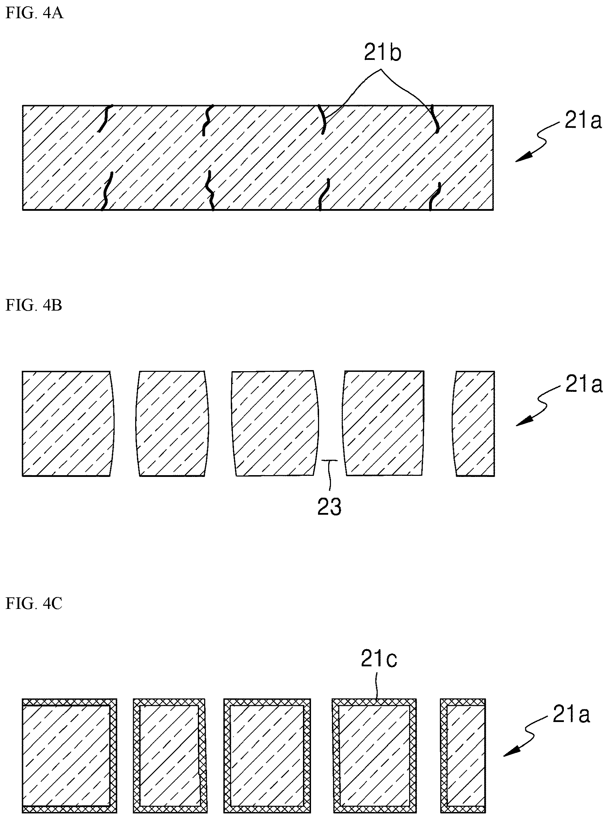

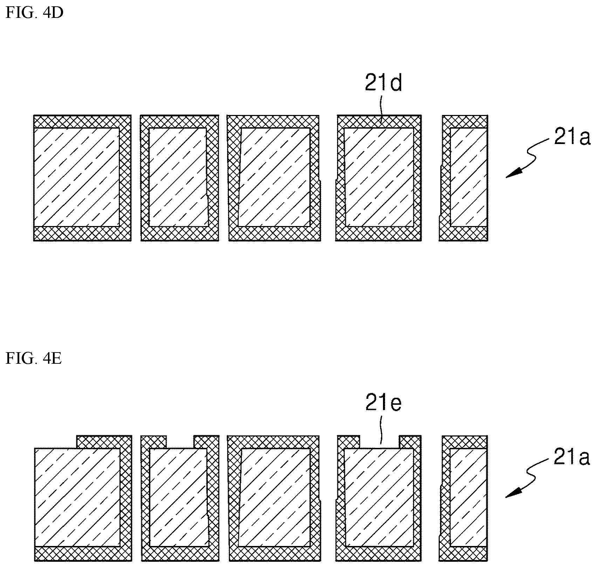

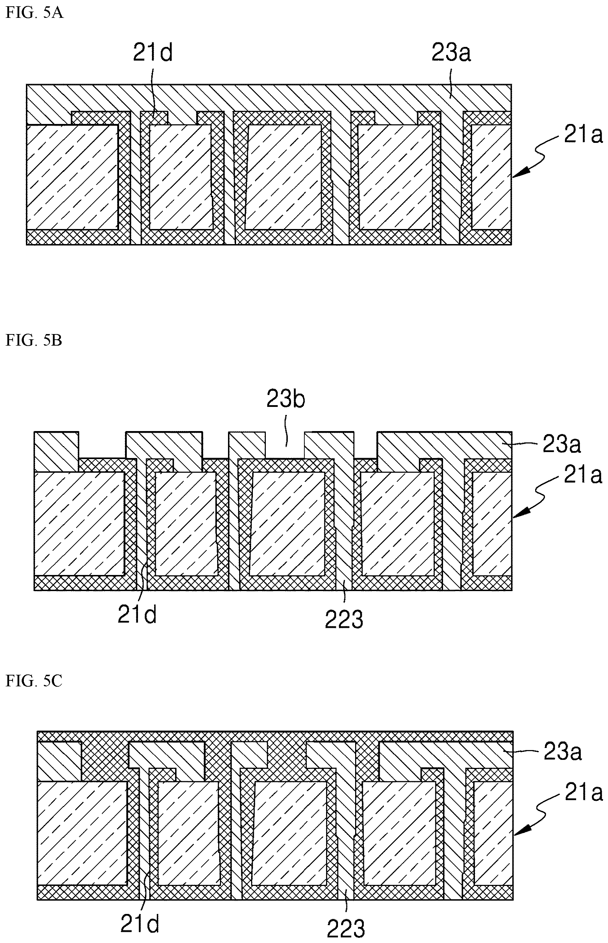

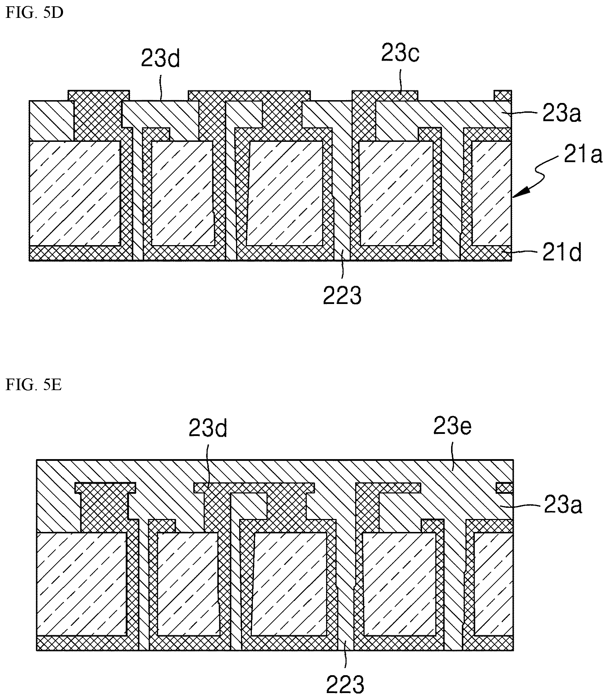

FIGS. 4 and 5 are flowcharts illustrating a cross-sectional view of the manufacturing process of a packaging substrate according to an embodiment.

First, a glass core 21a having a flat first and second surfaces is prepared, as shown in FIG. 4A, and a defect (groove, 21b) is formed on the glass surface at a predetermined position for forming a core via. The glass may be a glass core applied to a substrate of an electronic device or the like, and for example, an alkali-free glass core may be applied, but is not limited thereto. Commercially available products manufactured by manufacturers such as Corning, Schott, AGC, and the like may be applied. The defects (grooves) may be formed by mechanical etching, laser irradiation, or the like.

As shown in FIG. 4B, the glass core 21a in which the defect (groove, 21b) is formed is subjected to an etching operation to form a core via 23 through a physical or chemical etching process. During the etching process, the glass core forms vias in the defect portion and at the same time, the surface of the glass core 21a may be etched. A masking film or the like may be applied to prevent such etching of the glass surface, but the defective glass core itself may be etched in consideration of the cumbersome process of applying and removing the masking film, and in such a case, the thickness of the glass core having the core via may be somewhat thinner than the thickness of the initial glass core.

Then, a core layer preparing operation may be performed by forming an electrically conductive layer 21d on the glass core as shown in FIGS. 4C and 4D. The electrically conductive layer may be a metal layer comprising, but not limited to, copper metal.

The surface of the glass (comprising the surface of the glass core and the surface of the core via) and the surface of the copper metal have different properties, and the adhesion between them is poor. In an embodiment, the adhesion between the glass surface and the metal can be improved by two methods, a dry method and a wet method.

The dry method is a method of applying sputtering, that is, metal sputtering, to form a seed layer 21c on the surface of the glass and the inner diameter of the core via. In the formation of the seed layer, dissimilar metals such as titanium, chromium, nickel, and the like may be sputtered together with copper, and in this case, glass-to-metal adhesion may be improved by an anchor effect in which the surface morphology of the glass and the metal particles interact and the like.

The wet method is a primer treatment method in which a primer layer 21c is formed by pretreatment with a compound having functional groups such as amines. Depending on the degree of adhesion desired, pretreatment with a silane coupling agent can be followed by primer treatment with a compound or particle having an amine functional group. As mentioned above, the support substrate of the embodiment needs to be of high enough performance to form a fine pattern, which should be maintained after the primer treatment. Therefore, if such primer comprises nanoparticles, it is preferred that nanoparticles having an average diameter of 150 nm or less are applied, for example, particles having amine functional groups. The primer layer can be formed by applying a bonding force improver, for example, such as the CZ series of MEC.

The seed layer/primer layer 21c may form the electrically conductive layer with or without removing the portion where the formation of the electrically conductive layer is unnecessary, optionally. Furthermore, the seed layer/primer layer 21c may be optionally treated in an activated or deactivated state for metal plating with or without removing the portion where the formation of the electrically conductive layer is necessary or unnecessary to proceed with the subsequent process. For example, the activation or deactivation treatment may be subjected to light irradiation treatment such as a laser of a certain wavelength, chemical treatment, or the like. The formation of the metal layer may comprise, but is not limited to, copper plating methods applied in the manufacture of semiconductor devices.

As shown in FIG. 4E, a portion of the core distribution layer may be removed if it is unnecessary, and after the seed layer is partially removed or inactivated, metal plating may be performed to form an electrically conductive layer in a predetermined pattern to form the etching layer 21e of the core distribution layer.

FIG. 5 illustrates manufacturing operations to form an insulating layer and an upper distribution pattern, according to one embodiment.

As shown in FIG. 5A, the core via may be subjected an operation of forming to an insulating layer in which the void space is filled with an insulating layer after the formation of the core distribution layer, which is an electrically conductive layer. In this case, the insulating layer applied may be made in the form of a film, for example, by pressure sensitive lamination of the insulating layer in the form of a film. By performing such pressure-sensitive lamination, the insulating layer can be sufficiently impregnated into the void space inside the core vias to form a core insulating layer without void formation.

FIGS. 5B to 5E illustrate operations of forming an upper layer.

The operation of forming the upper layer is to form an upper layer comprising an upper insulating layer and an upper distribution pattern on the core layer. The upper insulating layer may be formed by coating a resin composition forming the insulating layer 23a or by laminating an insulating film, and the simpler method is to laminate an insulating film. The lamination of the insulating film may be carried out by laminating the insulating film and curing it, in which case, by applying a pressure sensitive lamination method, the insulating resin may be sufficiently impregnated in the core via, even in a layer where an electrically conductive layer is not formed. The upper insulating layer is also applied in direct contact with the glass core, at least in part, and thus has sufficient adhesion. Specifically, the glass core and the upper insulating layer are preferably characterized by an adhesion test value of 4B or more according to ASTM D3359.

The upper distribution pattern may be formed by repeating the process of forming the insulating layer 23a, forming the electrically conductive layer 23c in a predetermined pattern, and etching off the unnecessary parts to form the etching layer 23d of the electrically conductive layer, or, in the case of the electrically conductive layers that are formed adjacent to the insulating layer, forming a blind vias 23b on the insulating layer and then proceeding with the plating process. Dry etching methods such as laser etching, plasma etching, and the like, or wet etching methods using a masking layer and an etching solution, can be applied to form the blind vias.

Then, although not shown, an upper surface connection layer and a cover layer may be formed.

The upper surface connection pattern and the upper surface connection electrode may also be formed by a process similar to the formation of the upper layer. Specifically, it may be formed by forming an etching layer of an insulating layer on the insulating layer 23e, forming an electrically conductive layer thereon, forming an etching layer of an electrically conductive layer, and so on, but it may also be applied by selectively forming only the electrically conductive layer without applying the method of etching. The cover layer may be formed in such a way that an opening (not shown) is formed at a position corresponding to the upper surface connection electrode so that the upper surface connection electrode may be exposed and directly connected to an electrical connection or a terminal of the element.

Once the upper layer has been created, a lower layer can be processed by forming a lower surface connection layer and a cover layer. The lower layer and/or the lower surface connection layer, and optionally the cover layer (not shown), may be formed in a similar manner to the operations for forming the upper surface connection layer and cover layer described above.

As described above, the core layer may comprise a glass core, wherein the glass core may comprise a glass substrate having first and second surfaces facing each other. Further, as described above, the glass core may comprise a cavity portion. The cavity portion may be open and recessed in the direction of the first surface or the second surface or may have a space penetrating the glass core in which an electrical element is disposed.

The cavity portion may be recessed by opening in the direction of the first surface or second surface of the glass core or may have an internal space through the glass core to receive an electrical element. The cavity portion having an internal space that is recessed in the direction of the first surface or second surface of the glass core is referred to as a half cavity, and the cavity portion having an internal space through the glass core is referred to as a full cavity. An electronic element may be arranged in the internal space of the cavity portion.

In order to produce a glass core with a half cavity, the following methods are conventionally used.

One example of a conventional technique for fabricating a half cavity is using a single sheet of glass. Half cavities can be created by selectively irradiating a predetermined portion of the glass with energy and removing a portion of the glass, such as by mechanical ablation and/or chemical etching. In this case, a tapered zone with increasingly narrower gaps may be created at the edge of the cavity, and a wider margin area may be required. As a result, the element space available for mounting electronic elements in the cavity may be reduced.

As another example of a conventional technique for manufacturing a half-cavity, a method may be used in which a glass having a full cavity and a bottom glass are laminated to produce a glass core having a half-cavity. In this case, when the lamination process is repeatedly applied to the glass core to form electrodes in the vias or to form a distribution layer, the process of raising and lowering temperatures is repeatedly applied, and the laminated glasses are prone to delamination. This delamination problem also occurred when the polymer-based adhesive applied to the glass bonding was applied separately. Furthermore, when the full-cavity glass and the bottom glass are laminated after the core via is first generated, it may be troublesome to carefully align the full-cavity glass and the bottom glass. Accordingly, embodiments for manufacturing a half-cavity to solve the above problems are proposed herein.

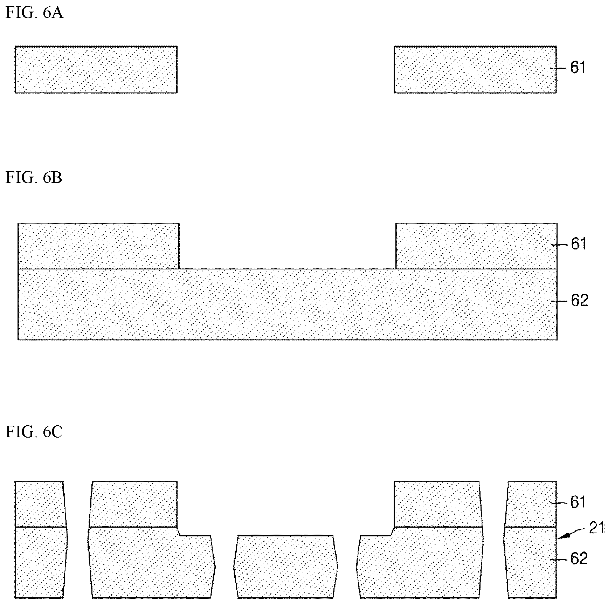

FIG. 6 is a cross-sectional flowchart illustrating a process for generating a glass core having a half cavity, according to an embodiment. Referring to FIG. 6, a manufacturing method of a packaging substrate will be described. Specifically, the present invention proposes a method for generating a glass core having a half cavity as follows.

A manufacturing method of a packaging substrate of an embodiment comprises a process of preparing a glass core, comprising an operation of forming a first core to join a first glass having a through cavity and a second glass; and an operation of etching the first core to form a plurality of core vias.

The operation of forming the first core comprises, for example, bonding a first piece of full cavity formed glass (first glass) to another piece of glass (second glass) to form the first core. In this case, the bonding may be anode bonding. The second glass may have a recessed surface, or the second glass may not have a recessed surface at the bonding procedure.

Subsequently, an etching operation is performed, i.e., the first core may be etched to form multiple core vias. This post-bonding formation of core vias can improve the efficiency of the process by eliminating the need to precisely bond the position of each formed core vias.

Etching may be applied by creating defects in the glass of the first core, which are etched by utilizing differences in etch rates. The formation of the defects may be exemplified by, but is not limited to, irradiation by a laser. The etching may be performed by forming a defect at the location where the core vias are to be formed and immersing the first core in the etchant.

The etchant may etch the surface of the first core where no defects have formed, not just where the defects have been created. Therefore, the thickness of the glass core may be thinner than the thickness of the first core.

The glass core thus formed has first and second surfaces facing each other, the core via being arranged with an internal space provided with a recessed surface opening in the direction of the first surface, the core via penetrating the glass core in the thickness direction. The specific description of the core via will be described in detail below and will not be described herein.

Referring to FIG. 6A, the first glass 61 has a cavity portion through the first glass 61.

Referring to FIG. 6B, the first glass 61 and the second glass 62 are bonded. Anodic bonding may be applied for the bonding. This process results in a first core. Anodic bonding is described later.

The first glass 61 in which the full cavity is formed is referred to as a cavity glass. By applying a cavity-formed glass as the first glass, the efficiency of the etching operation can be further improved.

The second glass 62 may be a glass without a cavity formed therein. The second glass 62 may be a bare glass.

The first glass 61 and the second glass 62 may each be applied with a plate glass that is independently applied to a semiconductor process. In addition, the first glass 61 and the second glass 62 may each independently be applied with a plate glass having the following characteristics.

At least one of the first glass 61 and the second glass 62 may have a content of Na₂O₃ in the glass of at least 2.5 wt%, at least 3 wt%, or at least 3.5 wt%. Further, the content of Na₂O₃ in the glass may be 6 wt% or less. When a glass having such a content of Na₂O₃ is applied to at least one of the first glass 61 and the second glass 62, an anodic bonding may be applied easily.

The first glass 61 and the second glass 62 may each have a maximum use temperature of 240 °C or higher, 250 °C or higher, 260 °C or higher, 280 °C or higher, or 300 °C or higher, and the maximum use temperature may be 600 °C or lower, 580 °C or lower, or 560 °C or lower. In such cases, it may have sufficient thermal durability during manufacturing and operation.

Preferably, the first glass 61 and the second glass 62 have a line thermal expansion coefficient α in °C that is substantially the same or has a negligible difference. The line thermal expansion coefficient may be 2.8*10E-6 to 4.5*10E-6, or 3*10E-6 to 4*10E-6.

Preferably, the first glass 61 and the second glass 62 have excellent chemical resistance. Specifically, the weight loss per unit area (cm²), when immersed in a 10 wt% hydrofluoric acid solution at 23 °C for 20 minutes, may be 2 mg or less or 1.5 mg or less. Specifically, immersion in a 5 wt% sodium hydroxide solution at 95 °C for 6 hours may result in a weight loss of 0.5 mg or less or 0.3 mg or less per unit area (cm²).

At least one of the first glass 61 and the second glass 62 may have a thermal diffusivity of 0.02 cm²/sec or less, or 0.01 cm²/sec or less. The thermal diffusivity may be greater than or equal to 0.0001 cm²/sec. The application of a glass with a lower thermal diffusivity may help to facilitate the application of processes such as bonding.

At least one of the first glass 61 and the second glass 62 may be, for example, but not limited to, Corning 7740 (Pyrex), Schott Glass Borofloat, and the like.

The glass core 21 produced by bonding the first glass 61 and the second glass 62 by an anodic bonding process or the like may have a bonding interface of the first glass 61 and the second glass 62. By applying an anodic bonding process or the like, it is characterized in that the bonding strength at the bonding interface is strong enough to substantially prevent delamination problems at the interface.

Referring to FIG. 6C, a mechanical etching and/or chemical etching method can be applied to form multiple core vias on the first core. In particular, in the case of the chemical etching method, a relatively large surface area can be etched simultaneously, which can improve process efficiency.

Chemical etching is a process in which a defect is formed in the first core by a method such as laser irradiation, and then an etching solution is applied to the first core to form core vias of a predetermined shape and size through an etching speed difference. In this way, a glass core 21 having multiple core vias penetrating in the thickness direction can be manufactured. In addition, the full cavity of the first glass corresponding to the cavity bottom surface of the first core and the upper surface of the second glass can also be etched by the above etching. The specific shape of the glass core will be described later.

The anodic bonding process is a bonding process that seals the glasses without introducing an additional intermediate layer, such as a polymeric bonding composition, between the glasses being joined.

At the interface, molecular bonds of Si and O located in the first and second glasses, respectively, are induced, resulting in a fairly strong interfacial bonding force, which can be sufficiently maintained even after repeated high-temperature processes that may be applied in the process of forming the glass core or packaging substrate, and the reliability of the product can be substantially maintained. The problem of delamination of the glass of the glass core 21 at the interface can be substantially prevented.

In other words, the glass core 21 comprises molecular bonding of Si, O at the interface between the first glass 61 and the second glass 62. This can be induced by an anodic bonding process.

Anodic bonding is a process that utilizes electricity, heat, and pressure to bond the interfaces of laminated materials. The process can be performed with equipment such as, but not limited to, the SB-6E Bonder or EVG 520IS. The anodic bonding process can be performed as follows 1) Place the surfaces to be bonded, which have been leveled and cleaned, against each other. In an embodiment, a laminate is prepared with a first glass and a second glass placed face to face. 2) Raise the temperature of the laminate and apply a voltage. The temperature may be, for example, 180 °C to 500 °C, but may be adjusted according to the characteristics of the glass. The voltage may be 200 to 1,000 V. The voltage may be applied. The voltage may be a DC voltage. At the above temperature and voltage, the glass is activated and charges such as sodium ions are allowed to move along with the voltage. At this time, the metal atoms (e.g., silicon) on the surface of the other glass and the oxygen atoms in the activated glass can meet each other to form interatomic bonds, and a strong bonding effect can be achieved by the formation of metal oxides at the interface. In addition, since a separate polymer adhesive layer is not applied, there is virtually no possibility of issues such as particles in the semiconductor manufacturing process, and the metal oxide formed at the interface by anodic bonding substantially overlaps with the components of the glass, making it easier to apply existing processes, such as the formation of vias during the etching operation.

The following describes the shape of the glass core formed by the etching operation.

As shown in FIG. 6C, for example, the glass core 21 has first and second surfaces facing each other. The glass core 21 comprises a plurality of core vias 23 penetrating the glass core 21 in a thickness direction. The glass core 21 is disposed with a cavity portion 28 having a recessed surface and an internal space arranged to open in the direction of the first surface.

The core via comprises a first opening abutting a first surface of the glass core 21, a second opening abutting a second surface of the glass core 21, and a minimum inner diameter region, which is a region having the narrowest inner diameter in the entire core via connecting the first opening and the second opening. The glass core 21 comprises a first core via and a second core via having different heights at which the minimum inner diameter region is disposed.

The second zone of the glass core 21 is the zone in which the cavity portion 28 is disposed in the glass core 21, and the first zone of the glass core 21 is the zone in which the cavity portion 28 is not disposed in the glass core 21.

The first core via is a core via disposed in the first zone, and the second core via is a core via disposed in the second zone.

The first core via has a minimum inner diameter region disposed at the first position, and the second core via has a minimum inner diameter region disposed at the second position.

With respect to the second surface, a minimum inner diameter height of the first core via may be positioned higher than a minimum inner diameter height of the second core via.

Further, as shown in FIG. 6C, the cavity portion 28 of the glass core 21 has a hexagonal-shaped internal space when viewed in cross-section.

The cavity portion 28 of the glass core 21 may be located such that the bottom surface of the half cavity is on or within the second glass.

The second glass has a recessed surface.

At the cavity portion 28 of the glass core 21, an angle of the sidewall surface at the through cavity of the first glass may be different with an angle of the sidewall surface at the recessed surface of the second glass. Specifically, with respect to the bottom surface of the second glass, the angle of the sidewall surface of the through cavity of the first glass is larger than the angle of the sidewall surface at the recessed surface of the second glass.

For example, the internal space of the cavity portion may comprise a first section 283 in which an angle of the sidewall surface is approximately 89 degrees to 90 degrees relative to the first or the second surface when viewed in cross-section, and a second section 284 in which an angle of the sidewall surface is inclined relative to the first or the second surface when viewed in cross-section.

By making the angle of the cavity side wall surface different between the first section 283 and the second section 284, the overall angle of the cavity side wall surface can be made closer to 90 degrees, which is advantageous for the pick-and-place tolerance of arranging the electronic elements while maintaining the element margins, and the space for the electronic elements to move after the pick-and-place process is reduced to prevent the electronic elements from leaving the designated arrangement position.

Further, as shown in FIG. 6C, in a packaging substrate according to one or more embodiments, the core layer comprises a glass core 21 having first and second surfaces facing each other; a cavity portion 28 having a surface recessed and hollowed out to open in the direction of the first surface; and a plurality of core vias 23 penetrating the glass core 21 in a thickness direction, wherein the glass core 21 comprises a first glass 21 and a second glass 62 stacked top and bottom. The first glass 21 comprises a through cavity.

The second region of the glass core 21 is the region in which the cavity portion 28 is arranged in the glass core 21, and the second glass 62 has a recessed expression. The sidewalls surface of the through-cavity of the first glass 61 and the sidewalls surface of the recessed surface of the second glass 62 are continuous with each other, and in a cross-section of the second region, the internal space of the cavity portion may have a hexagonal shape. Specifically, the opening may be treated as a straight line and the outline enclosed by the glass core may be substantially hexagonal in shape.

The internal space of the cavity portion may comprise a first section 283 recessed in the thickness direction with substantially uniform width and a second section 284 recessed in the thickness direction with increasingly narrowing width, i.e., the cavity portion may have a hexagonal shape with a contact point in contact with the first surface, an inflection point connecting the first section 283 and the second section 284, and a contact point in contact with the bottom surface of the cavity portion as vertices when viewed in cross-section.

For example, an interface of a first glass 61 and a second glass 62 may be formed at the point where the inflection point is located when viewed in cross-section. The first glass 61 may comprise the first section 283 of the cavity portion, and the second glass 62 may comprise the second section 284 of the cavity portion.

Electronic elements may be arranged in the internal space of the cavity portion 28. The electronic element 40 may be inserted and arranged in the internal space of the cavity portion 28.

For example, an electronic element may be selected and disposed in the internal space of the cavity portion (designation of the position of the electronic element). Alternatively, an element group comprising a plurality of electronic elements in a form embedded between an insulator layer (electronic element insulation layer) may be formed so that the electrodes are exposed and inserted into the internal space of the cavity portion. The electronic element 40 may comprise an active element, such as a transistor, or a passive element, such as a power transfer element, such as a multilayer ceramic capacitor (MLCC).

The lower part of the cavity portion formed in the glass core according to the embodiment described above, i.e., the second section 284, which is embedded in such a way that the gap becomes narrower and narrower in the thickness direction, enables the element margin to be maintained, which is advantageous for the pick-and-place tolerance of arranging the electronic elements, but also prevents the problem of the electronic elements deviating from the designated arrangement position by leaving less space for the electronic elements to move after the pick-and-place process. In addition, it can be advantageous in PVD processes as there is no misalignment when two sheets of glass forming the glass core are attached, and the etching process using bare glass can be reduced by one operation compared to the conventional method of creating a glass core with a half cavity.

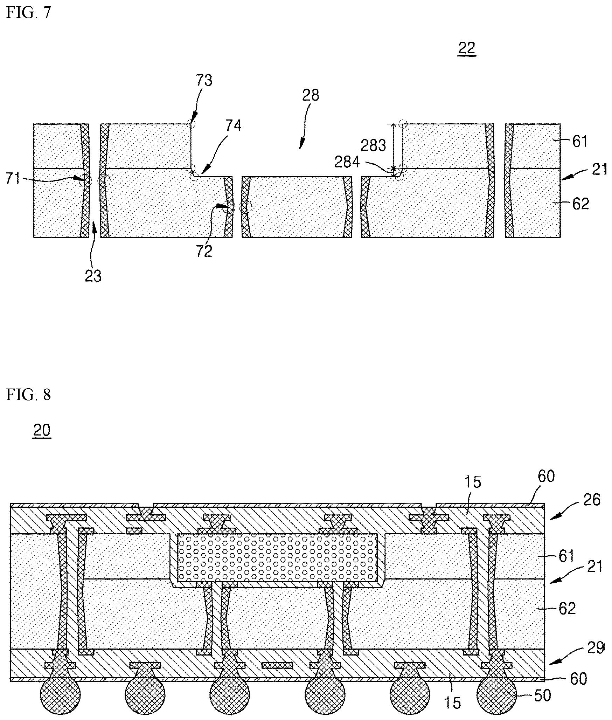

FIG. 7 is a conceptual diagram illustrating a cross-sectional view of a core layer comprising a glass core having a half cavity created in accordance with an embodiment. For example, embodiments of glass cores with half cavities proposed herein may be described as described hereinafter.

Referring to FIG. 7, the core layer 22 comprises a glass core 21 having first and second surfaces facing each other, a cavity portion 28 recessed in the direction of the first or the second surface and having an opening, and a plurality of core vias 23 penetrating the glass core 21 in the thickness direction.

For example, the core layer 22 may comprise a glass core 21 having first and second surfaces facing each other, the first region having a first thickness, and a second region having a second thickness where the cavity portion is located, and which is thinner than the first thickness. For example, the first thickness may be 400 µm or more, 500 µm or more, 600 µm or more, or 700 µm or more. The first thickness may be 1,500 µm or less, 1,400 µm or less, 1,300 µm or less, 1,200 µm or less, 1,100 µm or less, or 1,000 µm or less. The second thickness may be 200 µm or more, 300 µm or more, 400 µm or more, or 500 µm or more. The second thickness may be smaller than the first thickness. In this case, a glass core can be provided in which warpage of the core layer is reduced.

Specific descriptions of the features of the cavity portion, the features of the core vias, etc. are redundant to the descriptions given above and will not be described in detail.

The inflection point, where the side wall surface of the cavity abutting the first surface of the glass core, is called a first vertex point 73, and the inflection point where the bottom surface of the cavity and the side wall surface are called a second vertex point 74.

The taper angle of the side wall surface of the cavity portion can be measured in the following way. The angle, with respect to the second surface of the glass core, is an angle between an imaginary line passing through the first and second vertex points 73 and 74 and an imaginary line on the second surface perpendicular to the imaginary line.

The sidewall taper angle of an embodiment may be 87 degrees to 90 degrees, 88 degrees to 90 degrees, or 89 degrees to 90 degrees. A cavity portion having such an angle can substantially reduce the gap between the sidewall surface and an electronic element inserted into the cavity portion.

FIG. 8 is a conceptual diagram illustrating a cross-sectional view of the structure of a packaging substrate created in accordance with an embodiment. Referring to FIG. 8 to describe the packaging substrate of an embodiment, the packaging substrate has the features described in FIG. 6C and FIG. 7.

The packaging substrate 20 may have an electronic element 30 disposed in the cavity portion. The electronic elements may be connected up and down by an electrically conductive layer, and the electrically conductive layer passes through the internal space of the cavity portion and is connected to the bottom of the packaging substrate. In the internal space of the cavity, the empty area except the area where the cavity elements and the electrically conductive layer are disposed may be filled with an insulating material.

The packaging substrate 20 has a core layer 22 comprising an electrically conductive layer disposed on a glass core 21, and the core layer has the features described above. The packaging substrate 20 also has an upper layer 26 disposed on top of the core layer and having a predetermined pattern of electrically conductive layers and insulating materials covering the same, and a cover layer 60 disposed thereon. The packaging substrate 20 may further have a lower layer 29 disposed on the bottom of the core layer, on which the electrically conductive layer and the insulating material covering the same are disposed in a predetermined pattern, the cover layer 60 is disposed underneath, and the connection portion 50, such as a solder ball, is disposed.

In one or more embodiments, referring to FIGS. 7 and 8, the packaging substrate 20 comprises a core layer 22, wherein the core layer 22 comprises: a glass core 21 having first and second surfaces facing each other; and a plurality of core vias 23 penetrating the glass core in a thickness direction.

The glass core 21 may comprise a first glass and a second glass stacked up and down, and the interface of the first glass and the second glass may be bonded in a chemical structure forming a Si-O-Si or O-Si-O structure. The chemical structure may be induced by anodic bonding as described above. The glass core 21 may have O of the first glass and Si/Si of the second glass bonded together to form a Si-O-Si structure, such that a Si-O-Si structure is formed at the interface. In the glass core 21, the Si/Si of the first glass and the O of the second glass may be bonded to form an O-Si-O structure, such that an O-Si-O structure is formed at the interface. Although the anodic bonding is described based on Si, Al, a metal atom contained in the glass, can also be bonded with O to form a bonding structure at the interface.

The glass core 21 may substantially not comprise a polymeric adhesive layer at the interface of the first and second glasses.

The first glass comprises a through cavity.

The glass core further comprises a cavity portion 28 having a surface recessed and provided with an internal space to open in the first direction.

Specific features of the glass core, cavity, upper layer, lower layer, and each of the foregoing are redundant to the above description and are hereby omitted.

The manufacturing method of a packaging substrate according to the embodiments described above, and the packaging substrate utilizing the method, can strengthen the bonding force of the glasses forming a glass core with a half-cavity to prevent delamination of the glasses forming the glass core even after multiple high-temperature processes.

In addition, the glass core can be formed with a cavity portion comprising a lower section embedded in the glass core so that the gap becomes narrower and narrower in the thickness direction from a certain inflection point position, thereby maintaining the element margin, which is advantageous for the pick-and-place tolerance of arranging the electronic elements, but leaving less space for the electronic elements to move after the pick-and-place process to prevent the electronic elements from deviating from the specified arrangement position.

## Claims

1. A packaging substrate (20), comprising a core layer (22),
wherein the core layer (22) comprises a glass core (21) having first and second surfaces (213, 214) facing each other; a cavity portion (28) having a recessed surface and an internal space opened in the first direction; and a plurality of core vias (23) penetrating the glass core (21) in a thickness direction,
wherein the core via (23) comprises a first opening abutting the first surface (213); a second opening abutting the second surface (214); and a minimum inner diameter region having the narrowest inner diameter in the entire core via (23) connecting the first opening and the second opening,
wherein a first core via and a second core via having different heights at which the minimum inner diameter regions are disposed,
wherein the glass core (21) comprises a first glass (61) and a second glass (62) laminated up and down,
wherein the first glass (61) comprises a through cavity,
wherein the glass core (21) has a bonding interface between a lower surface of the first glass (61) and an upper surface of the second glass (62),
wherein the second glass (62) has the recessed surface,
wherein the internal space of the cavity portion (28) of the glass core (21) is hexagonal-shaped when viewed in cross-section, and
wherein, with respect to a bottom surface of the second glass (62), an angle of a side wall surface of the through cavity of the first glass (61) is larger than an acute angle of a side wall surface at the recessed surface of the second glass (62).

2. The packaging substrate of Claim 1,
wherein a second zone (222) of the glass core (21) is a zone in which the cavity portion (28) is disposed in the glass core (21), and a first zone (221) of the glass core (21) is a zone in which the cavity portion (28) is not disposed in the glass core (21),
wherein a first core via is disposed in the first zone (221) and has a minimum inner diameter region at a first position, and a second core via is disposed in the second zone (222) and has a minimum inner diameter region at a second position, and
wherein, with respect to the second surface (214), a height of the minimum inner diameter region of the first core via is higher than a height of the minimum inner diameter region of the second core via.

3. The packaging substrate of Claim 1,
wherein an electronic element (40) arranged in the internal space of the cavity portion (28), and the electronic element (40) comprises an active element.

4. The packaging substrate (20) of Claim 1,
wherein a second region of the glass core (21) is a region in which the cavity portion (28) is disposed in the glass core (21), and
wherein the side wall surface of the through cavity of the first glass (61) and the side wall surface of the recessed surface of the second glass (62) are continuous with each other, and, in a cross-section of the second region, the internal space of the cavity portion (28) is hexagonal in shape.

5. The packaging substrate of Claim 4,
wherein the cavity portion (28) is divided into a first section (283) for a section aligned with the first glass (61) and a second section (284) for a section aligned with the second glass (62), and
wherein a width of the cavity portion (28) of the second section is narrower than a width of the cavity portion (28) of the first section.

6. The packaging substrate of Claim 5,
wherein a taper angle of the sidewall surface of the cavity portion (28) is 87 degrees to 90 degrees.

7. A method for manufacturing the packaging substrate (20) of claim 1, wherein preparing the glass core (21) comprises operations of:
forming the glass core (21) by bonding the first glass (61) having the through cavity and the second glass (62) having the recessed surface, so that a cavity portion (28) of the glass core (21) having an hexagonal-shape when viewed in cross-section is formed, wherein, with respect to a bottom surface of the second glass (62), an angle of a side wall surface of the through cavity of the first glass (61) is larger than an acute angle of a side wall surface at the recessed surface of the second glass (62); and
etching the glass core (21) to form the plurality of core via (23), so that the core via (23) comprises a first opening abutting the first surface (213), a second opening abutting the second surface (214), and a minimum inner diameter region having the narrowest inner diameter in the entire core via (23) connecting the first opening and the second opening are formed, wherein a first core via and a second core via having different heights at which the minimum inner diameter regions are disposed, are formed.

8. The manufacturing method of the packaging substrate of Claim 7,
wherein, the bonding of the operation of forming a first core is anodic bonding.

## Patentansprüche

1. Verpackungssubstrat (20), umfassend eine Kernschicht (22),
wobei die Kernschicht (22) einen Glaskern (21) mit einer ersten und einer zweiten Oberfläche (213, 214), die einander zugewandt sind; einen Hohlraumabschnitt (28) mit einer vertieften Oberfläche und einem Innenraum, der in der ersten Richtung geöffnet ist; und eine Vielzahl von Kern-Vias (23), die den Glaskern (21) in einer Dickenrichtung durchdringen, umfasst,
wobei das Kern-Via (23) eine erste Öffnung, die an der ersten Oberfläche (213) anliegt; eine zweite Öffnung, die an der zweiten Oberfläche (214) anliegt; und einen Bereich mit minimalem Innendurchmesser mit dem engsten Innendurchmesser in dem gesamten Kern-Via (23), der die erste Öffnung und die zweite Öffnung verbindet, umfasst,
wobei ein erstes Kern-Via und ein zweites Kern-Via unterschiedliche Höhen aufweisen, an denen die Bereiche mit minimalem Innendurchmesser angeordnet sind,
wobei der Glaskern (21) ein erstes Glas (61) und ein zweites Glas (62), die auf und ab laminiert sind, umfasst,
wobei das erste Glas (61) einen Durchgangshohlraum umfasst,
wobei der Glaskern (21) eine Bindungsgrenzfläche zwischen einer unteren Oberfläche des ersten Glases (61) und einer oberen Oberfläche des zweiten Glases (62) aufweist,
wobei das zweite Glas (62) die vertiefte Oberfläche aufweist,
wobei der Innenraum des Hohlraumabschnitts (28) des Glaskerns (21) im Querschnitt gesehen sechseckig ist, und
wobei in Bezug auf eine untere Oberfläche des zweiten Glases (62) ein Winkel einer Seitenwandoberfläche des Durchgangshohlraums des ersten Glases (61) größer als ein spitzer Winkel einer Seitenwandoberfläche an der vertieften Oberfläche des zweiten Glases (62) ist.

2. Verpackungssubstrat nach Anspruch 1,
wobei eine zweite Zone (222) des Glaskerns (21) eine Zone ist, in der der Hohlraumabschnitt (28) in dem Glaskern (21) angeordnet ist, und eine erste Zone (221) des Glaskerns (21) eine Zone ist, in der der Hohlraumabschnitt (28) nicht in dem Glaskern (21) angeordnet ist,
wobei ein erstes Kern-Via in der ersten Zone (221) angeordnet ist und einen Bereich mit minimalem Innendurchmesser an einer ersten Position aufweist, und ein zweites Kern-Via in der zweiten Zone (222) angeordnet ist und einen Bereich mit minimalem Innendurchmesser an einer zweiten Position aufweist, und
wobei in Bezug auf die zweite Oberfläche (214) eine Höhe des Bereichs mit minimalem Innendurchmesser des ersten Kern-Vias höher als eine Höhe des Bereichs mit minimalem Innendurchmesser des zweiten Kern-Vias ist.

3. Verpackungssubstrat nach Anspruch 1,
wobei ein elektronisches Element (40) in dem Innenraum des Hohlraumabschnitts (28) angeordnet ist und das elektronische Element (40) ein aktives Element umfasst.

4. Verpackungssubstrat (20) nach Anspruch 1,
wobei ein zweiter Bereich des Glaskerns (21) ein Bereich ist, in dem der Hohlraumabschnitt (28) in dem Glaskern (21) angeordnet ist, und
wobei die Seitenwandoberfläche des Durchgangshohlraums des ersten Glases (61) und die Seitenwandoberfläche der vertieften Oberfläche des zweiten Glases (62) kontinuierlich miteinander sind und in einem Querschnitt des zweiten Bereichs der Innenraum des Hohlraumabschnitts (28) sechseckig ist.

5. Verpackungssubstrat nach Anspruch 4,
wobei der Hohlraumabschnitt (28) in einen ersten Abschnitt (283) für einen Abschnitt, der mit dem ersten Glas (61) ausgerichtet ist, und einen zweiten Abschnitt (284) für einen Abschnitt, der mit dem zweiten Glas (62) ausgerichtet ist, unterteilt ist, und
wobei eine Breite des Hohlraumabschnitts (28) des zweiten Abschnitts schmaler als eine Breite des Hohlraumabschnitts (28) des ersten Abschnitts ist.

6. Verpackungssubstrat nach Anspruch 5,
wobei ein Verjüngungswinkel der Seitenwandoberfläche des Hohlraumabschnitts (28) 87 Grad bis 90 Grad beträgt.

7. Verfahren zum Herstellen des Verpackungssubstrats (20) nach Anspruch 1, wobei das Herstellen des Glaskerns (21) die folgenden Vorgänge umfasst:
Bilden des Glaskerns (21) durch Binden des ersten Glases (61), das den Durchgangshohlraum aufweist, und des zweiten Glases (62), das die vertiefte Oberfläche aufweist, so dass ein Hohlraumabschnitt (28) des Glaskerns (21), der im Querschnitt gesehen sechseckig ist, gebildet wird, wobei in Bezug auf eine untere Oberfläche des zweiten Glases (62) ein Winkel einer Seitenwandoberfläche des Durchgangshohlraums des ersten Glases (61) größer als ein spitzer Winkel einer Seitenwandoberfläche an der vertieften Oberfläche des zweiten Glases (62) ist; und
Ätzen des Glaskerns (21), um die Vielzahl von Kern-Vias (23) zu bilden, so dass das Kern-Via (23) eine erste Öffnung, die an der ersten Oberfläche (213) anliegt, eine zweite Öffnung, die an der zweiten Oberfläche (214) anliegt, und einen Bereich mit minimalem Innendurchmesser mit dem engsten Innendurchmesser in dem gesamten Kern-Via (23), der die erste Öffnung und die zweite Öffnung verbindet, umfasst, wobei ein erstes Kern-Via und ein zweites Kern-Via mit unterschiedlichen Höhen, an denen die Bereiche mit minimalem Innendurchmesser angeordnet sind, gebildet werden.

8. Verfahren zum Herstellen des Verpackungssubstrats nach Anspruch 7,
wobei das Binden des Vorgangs des Bildens eines ersten Kerns anodisches Binden ist.

## Revendications

1. Substrat d'encapsulation (20), comprenant une couche de noyau (22),
où la couche de noyau (22) comprend un noyau en verre (21) avec une première et une deuxième surfaces (213, 214) se faisant face ; une partie de cavité (28) ayant une surface en retrait et un espace intérieur ouvert dans une première direction ; et une pluralité de trous d'interconnexion de noyau (23) pénétrant dans le noyau en verre (21) dans le sens de l'épaisseur,
où le trou d'interconnexion de noyau (23) comprend une première ouverture adjacente à la première surface (213) ; une deuxième ouverture adjacente à la deuxième surface (214) ; et une zone de diamètre intérieur minimal ayant le diamètre intérieur le plus étroit dans l'ensemble du trou d'interconnexion de noyau (23) reliant la première ouverture à la deuxième ouverture,
où un premier trou d'interconnexion de noyau et un deuxième trou d'interconnexion de noyau ont des hauteurs différentes où des zones de diamètre intérieur minimal sont présentées,
où le noyau en verre (21) comprend un premier verre (61) et un deuxième verre (62) stratifiés en haut et en bas,
où le premier verre (61) comprend une cavité traversante,
où le noyau en verre (21) a une interface de liaison entre une surface inférieure du premier verre (61) et une surface supérieure du deuxième verre (62),
où le deuxième verre (62) présente la surface en retrait,
où l'espace intérieur de la partie de cavité (28) du noyau en verre (21) est de forme hexagonale en vue en coupe transversale, et
où, par rapport à une surface inférieure du deuxième verre (62), un angle d'une surface de paroi latérale de la cavité traversante du premier verre (61) est supérieur à un angle aigu d'une surface de paroi latérale sur la surface en retrait du deuxième verre (62).

2. Substrat d'encapsulation selon la revendication 1,
où une deuxième zone (222) du noyau en verre (21) est une zone où la partie de cavité (28) est disposée dans le noyau en verre (21), et une première zone (221) du noyau en verre (21) est une zone où la partie de cavité (28) n'est pas disposée dans le noyau en verre (21),
où un premier trou d'interconnexion de noyau est disposé dans la première zone (221) et présente une zone de diamètre intérieur minimal à un premier emplacement, et un deuxième trou d'interconnexion de noyau est disposé dans la deuxième zone (222) et présente une zone de diamètre intérieur minimal à un deuxième emplacement, et
où, par rapport à la deuxième surface (214), une hauteur de la zone de diamètre intérieur minimal du premier trou d'interconnexion de noyau est supérieure à une hauteur de la zone de diamètre intérieur minimal du deuxième trou d'interconnexion de noyau.

3. Substrat d'encapsulation selon la revendication 1,
où un élément électronique (40) est disposé dans l'espace intérieur de la partie de cavité (28), et où l'élément électronique (40) comprend un élément actif.

4. Substrat d'encapsulation (20) selon la revendication 1,
où une deuxième zone du noyau en verre (21) est une zone où la partie de cavité (28) est disposée dans le noyau en verre (21), et
où la surface de paroi latérale de la cavité traversante du premier verre (61) et la surface de paroi latérale de la surface en retrait du deuxième verre (62) sont continues entre elles, et où, en section transversale de la deuxième zone, l'espace intérieur de la partie de cavité (28) est de forme hexagonale.

5. Substrat d'encapsulation selon la revendication 4,
où la partie de cavité (28) est divisée en une première section (283) pour une section alignée avec le premier verre (61) et une deuxième section (284) pour une section alignée avec le deuxième verre (62), et
où la largeur de la partie de cavité (28) de la deuxième section est inférieure à la largeur de la partie de cavité (28) de la première section.

6. Substrat d'encapsulation selon la revendication 5,
où un angle de conicité de la surface de paroi latérale de la partie de cavité (28) est compris entre 87 degrés et 90 degrés.

7. Procédé de fabrication du substrat d'encapsulation (20) selon la revendication 1, où la préparation du noyau en verre (21) comprend les opérations suivantes :
formation du noyau en verre (21) par liaison du premier verre (61) comportant la cavité traversante et du deuxième verre (62) comportant la surface en retrait, manière à former une partie de cavité (28) du noyau en verre (21) ayant une forme hexagonale en vue en coupe transversale, où, par rapport à une surface inférieure du deuxième verre (62), un angle d'une surface de paroi latérale de la cavité traversante du premier verre (61) est supérieur à un angle aigu d'une surface de paroi latérale sur la surface en retrait du deuxième verre (62) ; et
gravure du noyau en verre (21) pour former la pluralité de trous d'interconnexion de noyau (23), de sorte que le trou d'interconnexion de noyau (23) comprend une première ouverture aboutissant à la première surface (213), une deuxième ouverture aboutissant à la deuxième surface (214), et une zone de diamètre intérieur minimal ayant le diamètre intérieur le plus étroit dans l'ensemble du trou d'interconnexion de noyau (23) reliant la première ouverture à la deuxième ouverture, un premier trou d'interconnexion de noyau et un deuxième trou d'interconnexion de noyau ayant des hauteurs différentes où les zones de diamètre intérieur minimal sont présentées étant formés.

8. Procédé de fabrication du substrat d'encapsulation selon la revendication 7,
où la liaison de l'opération de formation d'un premier noyau est une liaison anodique.
